**Europäisches Patentamt**

**European Patent Office**

**Office européen des brevets**

(19)

(11) Veröffentlichungsnummer: **0 017 978**
**B1**

(12) # EUROPÄISCHE PATENTSCHRIFT

(45) Veröffentlichungstag der Patentschrift:
**25.05.83**

(51) Int. Cl.³: **H 01 L 23/04,** H 01 L 23/18

(21) Anmeldenummer: **80102044.7**

(22) Anmeldetag: **16.04.80**

(54) **Halbleiterbauelement mit scheibenförmigem Gehäuse.**

(30) Priorität: **19.04.79 DE 2915862**

(43) Veröffentlichungstag der Anmeldung:
**29.10.80 Patentblatt 80/22**

(45) Bekanntmachung des Hinweises auf die Patenterteilung:
**25.05.83 Patentblatt 83/21**

(84) Benannte Vertragsstaaten:
**FR GB SE**

(56) Entgegenhaltungen:
**FR-A-2 207 358**
**FR-A-2 335 955**
**US-A-4 099 201**

(73) Patentinhaber: **SIEMENS AKTIENGESELLSCHAFT,
Berlin und München Wittelsbacherplatz 2,
D-8000 München 2 (DE)**

(72) Erfinder: **Egerbacher, Werner, Vogelhartstrasse 4,
D-8000 München 40 (DE)**
Erfinder: **Wunderlich, Dieter, Prof. Schmid Strasse 95,
D-8031 Geiselbullach (DE)**

## Halbleiterbauelement mit scheibenförmigem Gehäuse

Die Erfindung betrifft ein Halbleiterbauelement mit scheibenförmigem, aus einem Keramikring und zwei mit diesem über Metallringe verbundenen Metallscheiben bestehenden Gehäuse, und mit einem Halbleiterkörper, der im Gehäuse zwischen den Metallscheiben angeordnet ist, und mit einer Isolierschicht zwischen dem Halbleiterkörper und der Innenseite des Keramikringes.

Halbleiterbauelemente mit scheibenförmigem Gehäuse werden bei Anlagen für hohe Leistungen eingesetzt. Da diese Anlagen hohe Dauerströme führen müssen, ist zu ihrem Schutz der Einsatz von Sicherungen unerläßlich. Diese Sicherungen müssen einen sehr hohen Ansprechstrom und damit ein hohes Explosionsintegral $\int i^2\, dt$ aufweisen. Das Explosionsintegral herkömmlicher scheibenförmiger Gehäuse ist jedoch in vielen Fällen geringer als das der Sicherungen. Das heißt, daß insbesondere bei hohen Kurzschlußströmen in Rückwärtsrichtung ein Lichtbogen im Halbleiterbauelement entsteht, der Halbleitermaterial und dünne Metallteile, zum Beispiel die obenerwähnten Metallscheiben des Gehäuses aufschmilzt, wobei der Lichtbogen und geschmolzenes Material explosionsartig nach außen dringt. Außerdem erhält der Keramikring einen Temperaturschock, der zur Rißbildung und damit zur Zerstörung der Keramik führen kann.

Zur Vermeidung dieser Nachteile ist es bekanntgeworden, die Innenseite des Keramikringes und mindestens die dünnen Metallringe auf der Innenseite mit einer Schicht aus Isolierstoff zu beschichten. Im montierten Zustand weist die Kunststoffbeschichtung aber mindestens eine Stoßstelle auf, durch die der Lichtbogen nach außen dringen und/oder die Keramik beschädigen kann.

Der Erfindung liegt die Aufgabe zugrunde, ein Halbleiterbauelement der eingangs erwähnten Art so weiterzubilden, daß eine Beschädigung der Keramik und ein Entweichen von schmelzflüssigem Material innerhalb des in Frage kommenden Bereiches des Explosionsintegrals $\int i^2\, dt$ unmöglich wird.

Die Erfindung ist gekennzeichnet durch je einen innerhalb des Gehäuses am Umfang jeder der Metallscheiben angebrachten Metallring und durch mindestens eine die Innenseite des Keramikringes überdeckende und die Metallringe auf ihrer dem Gehäuseinneren zugewandten Seite überlappende, elektrisch und thermisch isolierende Folie hoher Verdampfungsenergie.

Ausgestaltungen der Erfindung sind Gegenstand der Unteransprüche.

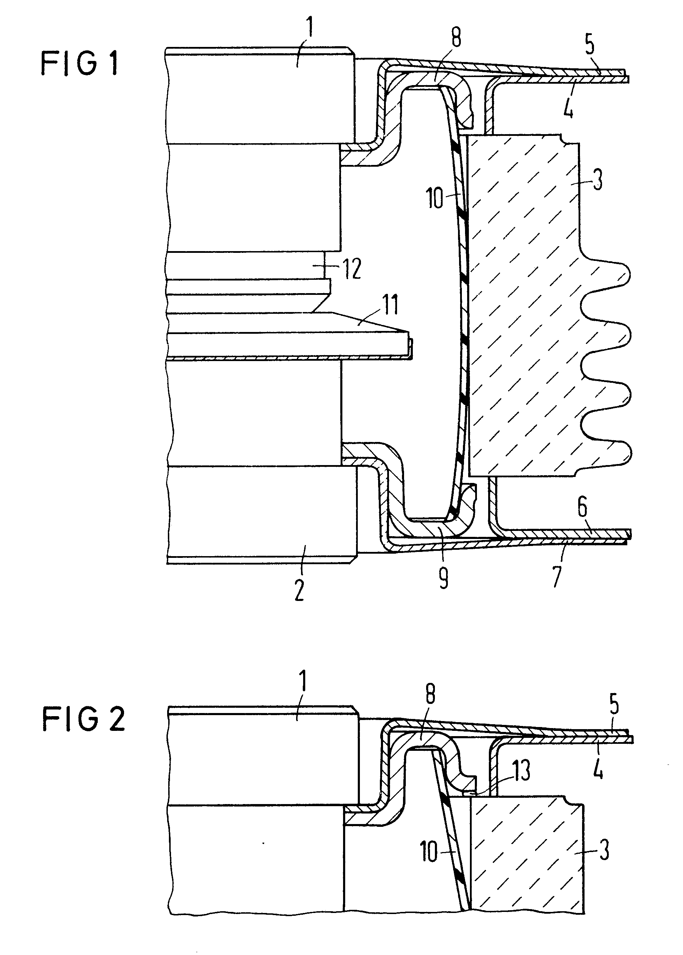

Die Erfindung wird an Hand dreier Ausführungsbeispiele in Verbindung mit den Fig. 1 bis 3 näher erläutert. Die Fig. 1 bis 3 zeigen jeweils einen Teilschnitt durch ein scheibenförmiges Gehäuse für ein Halbleiterbauelement. Gleiche und funktionsgleiche Teile sind in den Figuren mit gleichen Bezugszeichen versehen.

Das in Fig. 1 dargestellte Gehäuse besteht aus zwei metallenen Deckplatten 1, 2, die über dünne, flexible Metallringe mit den Stirnflächen eines Keramikringes 3 verbunden sind. Die Metallringe können beispielsweise jeweils aus zwei flanschartigen Teilen 4, 5 beziehungsweise 6, 7 zusammengesetzt sein. Die flanschartigen Teile 4, 6 werden mit der Stirnseite des Keramikringes beispielsweise hart verlötet. Die Teile 5, 7 können mit den Deckplatten 1, 2 hart verlötet sein. Beim Abdichten des Gehäuses werden dann die Teile 4, 5 beziehungsweise 6, 7 miteinander verschweißt.

Zwischen den beiden Metallscheiben 1, 2 liegt ein Halbleiterkörper 11, der mit den Metallscheiben 1, 2 unmittelbar oder unter Zwischenlage einer Kontaktscheibe 12 mittelbar kontaktiert sein kann. Am Umfang der Metallscheiben 1, 2 sind, konzentrisch zu diesen, Metallringe 8, 9 zum Beispiel durch Aufschrumpfen oder Verstemmen befestigt. Diese Metallringe sind mit parallel zur Umfangsrichtung verlaufenden Einprägungen versehen, wobei die konkave Seite der Einprägung zur Innenseite des Gehäuses zeigt. Zur Vermeidung unerwünschter Geräuschentwicklung im Betrieb können diese Metallringe aus amagnetischem Metall, zum Beispiel aus amagnetischem Stahl, bestehen.

Im Gehäuseinneren ist eine thermisch und elektrisch isolierende Kunststoffolie 10 angeordnet, die den Halbleiterkörper 11 umgibt und die Innenseite des Keramikringes 3 bedeckt. Die Folie 10 reicht in die Einprägungen der Metallringe 8, 9 hinein und überlappt diese somit. Die Folie 10 besteht aus einem Material hoher Verdampfungsenergie, zum Beispiel Polytetrafluoräthylen (PTFE), Fluoräthylenpropylen (FEP) oder aus einem Polyimid.

Bei einem Kurzschluß wird damit der entstehende Lichtbogen nicht unmittelbar mit dem Keramikzylinder 3 und den dünnen, flexiblen Metallringen in Berührung kommen können. Damit wird der Temperaturschock für den Keramikring 3 so weit abgemildert, daß keine Risse entstehen können. Ein Durchbrennen der flexiblen Metallringe wird durch die Metallringe 8, 9 bis zum Ansprechen der Sicherungen verhindert. Die Metallringe können, wenn sie aus Stahl bestehen, eine Dicke zwischen 1 und 2 mm haben. Ringe aus anderen Metallen können je nach ihrem Schmelzpunkt dünner oder dicker ausgebildet sein. Die Folie kann zum Beispiel 0,5 mm dick sein und in einer oder mehreren Lagen übereinander angewendet werden. Ein Austreten von geschmolzenem Material zwischen den Metallringen und der Folie wird durch die Überlappung beider Teile sicher verhindert, da der im Inneren auftretende Druck die Folien an den Rand der Metallringe anpreßt.

Zwischen der Stirnseite des Keramikringes 3 und dem Außenrand der Metallringe kann noch eine zusätzliche Dichtung 13 (Fig. 2) angebracht sein. Diese Dichtung kann beispielsweise aus einem elastischen Lack, zum Beispiel Silikonlack, bestehen.

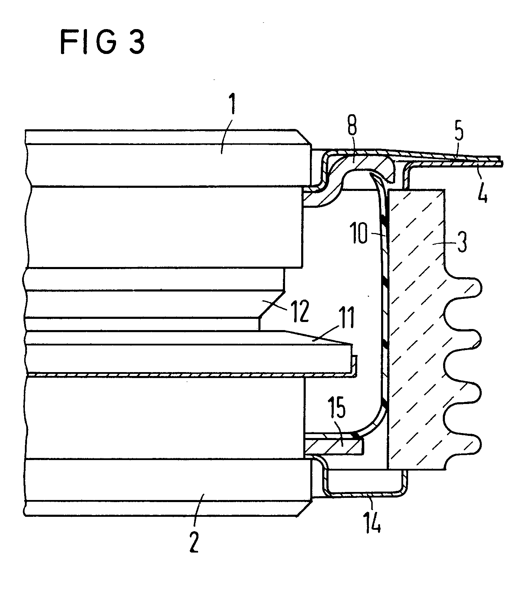

Im Ausführungsbeispiel nach Fig. 3 ist anstelle des unteren, mit einer Einprägung versehenen, zur Metallplatte 2 konzentrisch liegenden Metallringes ein planer Metallring 15 mit der Metallplatte 2 verbunden. Die Folie 10 überlappt den Metallring 15 und dichtet das Innere gegen das Austreten von geschmolzenem Material ab. Auch dieser Metallring kann aus amagnetischem Stahl bestehen. Er kann ebenfalls 1 bis 2 mm dick sein. Der Außenrand des Metallringes 15 liegt dabei der Innenseite des Keramikringes 3 gegenüber. Zur Verbindung der Metallplatte 2 mit dem Keramikring 3 dient hier ein etwas anders geformter flexibler Metallring 14, der im Kurzschlußfall zuverlässig gegen den auftretenden Lichtbogen geschützt wird.

## Patentansprüche

1. Halbleiterbauelement mit scheibenförmi-gem, aus einem Keramikring und zwei mit diesem über Metallringe verbundenen Metallscheiben bestehenden Gehäuse und mit einem Halbleiterkörper, der im Gehäuse zwischen den Metallscheiben angeordnet ist, und mit einer Isolierschicht zwischen dem Halbleiterkörper und der Innenseite des Keramikringes, gekennzeichnet durch je einen innerhalb des Gehäuses am Umfang jeder der Metallscheiben (1, 2) angebrachten Metallring (8, 9, 15) und durch mindestens einen die Innenseite des Keramikringes (3) überdeckende und die Metallringe (8, 9, 15) auf ihrer dem Gehäuseinneren zugewandten Seite überlappende, elektrisch und thermisch isolierende Folie (10) hoher Verdampfungsenergie.

2. Halbleiterbauelement nach Anspruch 1, dadurch gekennzeichnet, daß mindestens einer der Metallringe (8, 9) mit einer parallel zur Umfangsrichtung verlaufenden Einprägung versehen ist, deren konkave Seite zur Innenseite des Gehäuses zeigt, daß der Außenrand des Metallringes die Stirnseite des Keramikringes (3) überlappt und daß die Folie (10) in die Einprägung hineinreicht.

3. Halbleiterbauelement nach Anspruch 2, dadurch gekennzeichnet, daß zwischen dem Außenrand des Metallringes (8) und der Stirnseite des Keramikringes (3) eine Dichtung (13) liegt.

4. Halbleiterbauelement nach einem der Ansprüche 1 bis 3, dadurch gekennzeichnet, daß einer der Metallringe (15) wenigstens annähernd plan ist und daß sein Außenrand der Innenseite des Keramikringes (3) gegenüberliegt.

5. Halbleiterbauelement nach einem der Ansprüche 1 bis 4, dadurch gekennzeichnet, daß die Metallringe (8, 9, 15) aus amagnetischem Stahl bestehen.

## Claims

1. Semiconductor component comprising a disc-shaped housing which comprises a ceramic ring and two metal discs connected to the former by means of metal rings, and comprising a semiconductor body which is arranged in the housing between the metal discs, and comprising an insulating layer between the semiconduc-tor body and the inside of the ceramic ring, characterised by a metal ring (8, 9, 15) which is applied within the housing to the periphery of each of the metal discs (1, 2) and by at least one electrically and thermally insulating film (10) which has high evaporation energy and covers the inside of the ceramic ring (3) and overlaps the metal rings (8, 9, 15) on its side facing the inside of the housing.

2. Semiconductor component as claimed in claim 1, characterised in that at least one of the metal rings (8, 9) is provided with an indentation which runs parallel to the peripheral direction and whose concave side points to the inside of the housing, and that the outer edge of the metal ring overlaps the front side of the ceramic ring (3), and that the film (10) extends into the indentation.

3. Semiconductor component as claimed in claim 2, characterised in that between the outer edge of the metal ring (8) and the front side of the ceramic ring (3), there is arranged a seal (13).

4. Semiconductor component as claimed in one of claims 1 to 3, characterised in that one of the metal rings (15) is at least approximately plane and that its outer edge lies opposite the inside of the ceramic ring (3).

5. Semiconductor component as claimed in one of claims 1 to 4, characterised in that the metal rings (8, 9, 15) consist of non-magnetic steel.

## Revendications

1. Composant à semiconducteurs avec un boîtier en forme de disque constitué par une bague en céramique et par deux disques métalliques reliés à celle-ci par des bagues métalliques, et avec un corps semiconducteur disposé dans le boîtier entre les disques métalliques, ainsi qu'avec une couche isolante entre le corps semiconducteur et le côté intérieur de la bague en céramique, caractérisé par une bague métallique (8, 9, 15) disposée à l'intérieur du boîtier et fixée respectivement à la périphérie de chacun des disques métalliques (1, 2) et par au moins une feuille (10) à haute énergie de vaporisation, électriquement et thermiquement isolante, recouvrant le côté intérieur de la bague en céramique (3) et recouvrant les bagues métalliques (8, 9, 15) sur leur côté tourné vers l'intérieur du boîtier.

2. Composant à semiconducteurs selon la revendication 1, caractérisé par le fait qu'au moins l'une des bagues métalliques (8, 9) est pourvue d'une empreinte s'étendant parallèlement à la direction périphérique, dont le côté concave est dirigé vers le côté intérieur du boîtier, que le bord extérieur de la bague métallique recouvre le côté frontal de la bague en céramique (3) et que la feuille (10) pénètre dans l'empreinte.

3. Composant à semiconducteurs selon la revendication 2, caractérisé par le fait qu'entre le bord extérieur de la bague métallique (8) et le côté frontal de la bague en céramique (3) est disposé un moyen d'étanchéité (13).

4. Composant à semiconducteurs selon l'une des revendications 1 à 3, caractérisé par le fait que l'une des bagues métalliques (15) est au moins à peu près plane et que son bord extérieur est situé en face du côté intérieur de la bague en céramique (3).

5. Composant à semiconducteurs selon l'une des revendications 1 à 4, caractérisé par le fait que les bagues métalliques (8, 9, 15) sont constituées avec un acier amagnétique.

FIG 1

FIG 2

FIG 3